# EUROPÄISCHE PATENTSCHRIFT

(11) **EP 0 753 935 B1**
(45) Veröffentlichungstag und Bekanntmachung des Hinweises auf die Patenterteilung: **28.11.2001**
(21) Anmeldenummer: 96201859.4
(22) Anmeldetag: 04.07.1996
(51) Int. Cl.: H03F 3/68

(54) **Signalverstärker**
Signal amplifier
Amplificateur de signaux

(30) Priorität: 12.07.1995 DE 19525411
(43) Veröffentlichungstag der Anmeldung: 15.01.1997
(73) Patentinhaber: Philips Corporate Intellectual Property GmbH, 52064 Aachen (DE); Koninklijke Philips Electronics N.V., 5621 BA Eindhoven (NL)
(72) Erfinder: Dünnebacke, Joachim, Röntgenstrasse 24 22335 Hamburg (DE)
(74) Vertreter: Peters, Carl Heinrich, Dipl.-Ing.

(56) Entgegenhaltungen:
- EP-A- 0 613 242

## Beschreibung

Die Erfindung bezieht sich auf einen Signalverstärker mit vier in zwei verschiedenen Schaltungskonfigurationen verbindbaren Verstärkerstufen, wobei in der ersten Schaltungskonfiguration zwischen Ausgangsanschlüssen einer ersten und einer dritten der Verstärkerstufen eine Serienschaltung zweier Lasten angeordnet und einem Verbindungspunkt zwischen den Lasten ein Bezugspotential, einem Eingang der ersten Verstärkerstufe ein erstes zu verstärkendes Signal und einem Eingang der dritten Verstärkerstufe ein zweites zu verstärkendes Signal zuführbar ist, und wobei in der zweiten Schaltungskonfiguration zwischen dem Ausgangsanschluß der ersten Verstärkerstufe und einem Ausgangsanschluß einer zweiten Verstärkerstufe eine erste der Lasten und zwischen dem Ausgangsanschluß der dritten Verstärkerstufe und einem Ausgangsanschluß einer vierten Verstärkerstufe eine zweite der Lasten angeordnet und dem Eingang der ersten Verstärkerstufe sowie einem Eingang der zweiten Verstärkerstufe das erste zu verstärkende Signal und dem Eingang der dritten Verstärkerstufe sowie einem Eingang der vierten Verstärkerstufe das zweite zu verstärkende Signal zuführbar ist, und mit einer Umschalteinrichtung zum Umschalten des Signalverstärkers wahlweise in eine der beiden Schaltungskonfigurationen.

Ein derartiger Signalverstärker ist aus der EP 0 613 242 A1 bekannt. Der dort beschriebene, selbst-konfigurierbare Leistungsverstärker ist mit einem Fensterkomparator ausgerüstet, der den Pegel der Eingangssignale, die dem Verstärker zugeleitet werden, detektiert. Über eine Reihe von Konfigurationsschaltern kann der Verstärker als Einzelbrückenverstärker oder als zwei einzelne Brückenverstärker konfiguriert werden. So lange die Pegel der Eingangssignale innerhalb eines Bereiches liegen, der durch eine negative und eine positive Spannungsreferenz gebildet wird, ist der Verstärker als Einzelbrückenverstärker konfiguriert. Wenn dagegen die Augenblickswerte der Eingangssignale über die genannten Spannungsreferenzen ansteigen, wechselt der Fensterkomparator seinen Zustand und schaltet die Konfiguration des Verstärkers in diejenige mit zwei einzelnen Brückenverstärkern um. Dadurch wird die Verlustleistung des Verstärkers bei Eingangssignalen, deren Augenblickswerte sich innerhalb des "Fensters" des Komparators befinden, auf etwa ein Viertel der Verlustleistung der beiden einzelnen Brückenverstärker begrenzt. Insgesamt kann damit die Verlustleistung des Verstärkers verringert werden.

Bei der bekannten Anordnung wird das Umschaltkriterium für die Verstärkerkonfiguration aus einem Vergleich der Pegel der Eingangssignale, ggf. auch der Ausgangssignale, mit einer Spannungsreferenz gewonnen. Es hat sich gezeigt, daß dies bei schwankenden Betriebsspannungen, wie sie insbesondere bei Einsetzen in Kraftfahrzeugen vorkommen, zu Nachteilen führt. Außerdem neigen die in der bekannten Schaltungsanordnung vorhandenen Rückkopplungsschleifen zu parasitären Schwingungen.

Die Erfindung hat die Aufgabe, eine Schaltungsanordnung der eingangs genannten Art in der Weise auszubilden, daß die vorstehenden Nachteile behoben werden. Insbesondere sollen die Einflüsse schwankender Betriebsspannungen auf die Konfiguration des Signalverstärkers und damit letztlich auf die Wiedergabequalität von ihm abgegebener Signale unterdrückt werden.

Diese Aufgabe wird erfindungsgemäß bei einem Signalverstärker der gattungsgemäßen Art gelöst durch eine Detektionseinrichtung zum Detektieren des Klirrfaktors des Signals am Ausgangsanschluß der ersten und/oder der dritten Verstärkerstufe und zum Betätigen der Umschalteinrichtung in Abhängigkeit vom detektierten Wert des Klirrfaktors.

Beim erfindungsgemäßen Signalverstärker dienen somit nicht mehr fest vorgegebene Spannungsreferenzen als Schaltschwellen für den "Fensterkomparator"; vielmehr wird anhand des Klirrfaktors unmittelbar die Wiedergabegüte des Signals am Ausgangsanschluß bestimmt. So lange der Klirrfaktor und damit die Verzerrungen des Signals am Ausgangsanschluß hinreichend niedrig sind, d.h. so lange die Wiedergabegüte hinreichend hoch ist, befindet sich der Signalverstärker in der ersten Schaltungskonfiguration, in der er eine niedrige Verlustleistung aufweist. Erst wenn der Klirrfaktor ansteigt und damit die Wiedergabegüte nachläßt, wird in die mit höherer Verlustleistung behaftete, jedoch auch für höhere Amplituden geeignete, zweite Schaltungskonfiguration umgeschaltet. Damit wird die Wiedergabegüte auch bei schwankenden Betriebsspannungen auf einem hohen Niveau gehalten, ohne daß die Verlusleistung unnötig hoch wird. Tritt nämlich bei schwankender Betriebsspannung ein erhöhter Klirrfaktor bei unterschiedlichen Pegeln bzw. Amplituden des zu verstärkenden Signals auf, wird erfindungsgemäß das Umschalten zwischen den beiden Schaltungskonfigurationen dem Einsatzpunkt des Ansteigens des Klirrfaktors über den zulässigen Wert hinaus angepaßt. Bei einem Vergleich des Pegels des Eingangssignals mit einem festen Referenzpotential müßte dagegen ein weiter Sicherheitsbereich berücksichtigt und entsprechend das "Fenster" so schmal gewählt werden, daß auch bei ungünstiger Betriebsspannung der Klirrfaktor begrenzt bleibt. Die Erfindung ermöglicht es, die Aussteuerungsbereiche für das Eingangssignal, d.h. das zu verstärkende Signal, in jedem Fall, d.h. für alle Werte der Betriebsspannung, vollständig auszunutzen und so möglichst lange im verlustarmen Betrieb der ersten Schaltungskonfiguration zu bleiben. Vorzugsweise ist die erfindungsgemäße Schaltungsanordnung dabei so eingerichtet, daß durch die Umschalteinrichtung in die erste Schaltungskonfiguration umgeschaltet werden kann, wenn der detektierte Wert des Klirrfaktors einen vorgebbaren Grenzwert unterschreitet, und daß anderenfalls in die zweite Schaltungskonfiguration umgeschaltet werden kann.

Die Detektionseinrichtung kann bevorzugt einen Augenblickswert des Klirrfaktors bestimmen. Dazu kann grundsätzlich der Augenblickswert einer oder mehrerer Oberschwingungen des zu verstärkenden Signals im Signal am Ausgang des Signalverstärkers im Vergleich zum Augenblickswert der Grundschwingung des zu verstärkenden Signals in seiner verstärkten Form als Signal am Ausgang des Signalverstärkers verglichen werden, wobei ein Ansteigen des Augenblickswerts der Oberschwingungen gleichbedeutend mit einem Anstieg des Klirrfaktors ist und unmittelbar das Umschalten in die zweite Schaltungskonfiguration auslöst. Die Umschaltung kann jedoch auch derart erfolgen, daß die Detektionseinrichtung den Klirrfaktor in Abhängigkeit von der Signalamplitude bestimmt und bei Überschreiten eines Grenzwertes aus der Signalamplitude einen Umschaltpegel festlegt, bei dessen Überschreiten durch den Augenblickswert des Signals von der ersten in die zweite Schaltungskonfiguration umgeschaltet wird. Das Umschalten erfolgt aber auch hier nicht an fest vorgegebenen Spannungsgrenzwerten; vielmehr werden aus der Detektion des Klirrfaktors Umschaltpegel ermittelt, oberhalb derer das Ausgangssignal einen unzulässig hohen Klirrfaktor annimmt oder das Eingangssignal, d.h. das zu verstärkende Signal, ein Ausgangssignal mit einem unzulässig hohen Klirrfaktor erzeugt. Treten hierbei Verschiebungen der Betriebsspannung auf, wird der Umschaltpegel entsprechend selbsttätig angepaßt. Der Umschaltpegel kann dabei wahlweise so ausgebildet werden, daß das zu verstärkende Signal oder das Signal am Ausgang des Signalverstärkers mit dem Umschaltpegel verglichen werden können.

In einer anderen Ausgestaltung der Erfindung detektiert die Detektionseinrichtung einen Übergang der ersten und/oder der dritten Verstärkerstufe in einen Sättigungszustand. Vor Erreichen des Sättigungszustandes wird in die erste und im Sättigungszustand wird in die zweite Schaltungskonfiguration umgeschaltet. Die Detektion des Sättigungszustandes bildet eine einfache Möglichkeit zur Bestimmung des Ansteigens des Klirrfaktors, da letzterer insbesondere durch die mit Erreichen des Sättigungszustands einsetzenden Nichtliniaritäten hervorgerufen wird.

Um in beiden Schaltungskonfigurationen exakt übereinstimmende Verstärkungsfaktoren zu erzielen und damit eine verzerrungsarme Signalverstärkung sicherzustellen, wird nach einer anderen Weiterbildung der Erfindung durch je eine gemeinsam mit der Umschalteinrichtung betätigbare Verstärkungs-Umsteuereinrichtung in der ersten und der dritten Verstärkerstufe der Verstärkungsfaktor dieser Verstärkerstufen in der ersten Schaltungskonfiguration auf einen ersten Wert und in der zweiten Schaltungskonfiguration auf einen zweiten, niedrigeren Wert umgesteuert. Dadurch wird dem Umstand Rechnung getragen, daß in der zweiten Schaltungskonfiguration auch die zweite und die vierte Verstärkerstufe an der Signalverstärkung teil haben.

Bevorzugt ist in der ersten Schaltungskonfiguration das Bezugspotential dem Verbindungspunkt der Lasten über die zweite und/oder die vierte Verstärkerstufe zuleitbar. Grundsätzlich können dabei sowohl die zweite als auch die vierte Verstärkerstufe an ihren Ausgängen das Bezugspotential führen. In der Praxis können jedoch durch Fertigungstoleranzen geringe Potentialunterschiede an den Ausgängen der genannten Verstärkerstufen auftreten. Diese können unerwünschte, zusätzliche Verluste hervorrufende Ausgleichsströme auslösen. Bevorzugt wird daher entweder die zweite oder die vierte Verstärkerstufe in der ersten Schaltungskonfiguration in eine Betriebsart mit hochohmigem Ausgangsanschluß geschaltet, um die Ausgleichsströme zu unterbinden.

Ein Ausführungsbeispiel der Erfindung ist in der Zeichnung dargestellt und wird im folgenden näher beschrieben. Dabei zeigt:
Fig. 1 ein schematisches Blockschaltbild des Ausführungsbeispiels und
Fig. 2 ein Diagramm zur Erläuterung der Schaltungsanordnung nach Fig. 1.

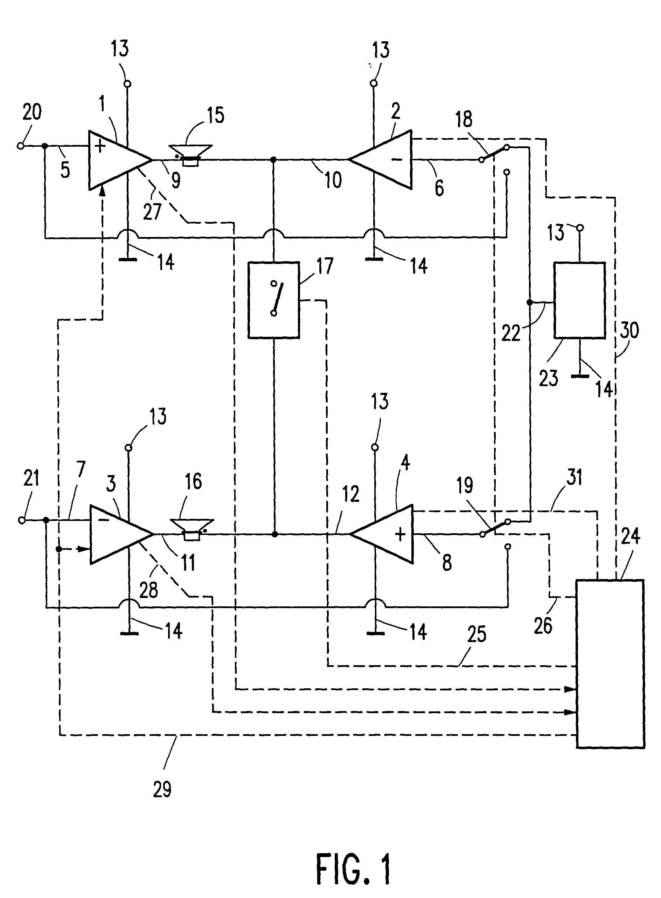

In Fig. 1 sind mit den Bezugszeichen 1 bis 4 eine erste, zweite, dritte bzw. vierte Verstärkerstufe bezeichnet. Die Teile eines erfindungsgemäßen Signalverstärkers bilden. Jede der Verstärkerstufen 1 bis 4 weist einen Eingang 5, 6, 7 bzw. 8, einen Ausgangsanschluß 9, 10, 11 bzw. 12, einen - im vorliegenden Beispiel gemeinsamen - Betriebsspannungsanschluß 13 und einen Masseanschluß 14 auf. Zwischen den Ausgangsanschlüssen 9 und 10 der ersten und der zweiten Verstärkerstufe 1 bzw. 2 ist eine erste Last 15, zwischen den Ausgangsanschlüssen 11 und 12 der dritten und vierten Verstärkerstufe 3 bzw. 4 ist eine zweite Last 16 angeordnet. Beide Lasten 15, 16 sind in Fig. 1 durch Lautsprecher gebildet. Außerdem sind der Ausgangsanschluß 10 der zweiten Verstärkerstufe 2 und der Ausgangsanschluß 12 der vierten Verstärkerstufe 4 über einen ersten Schalter 17 miteinander verbunden. Im leitenden Zustand des ersten Schalters 17 bildet dieser einen Verbindungspunkt, durch den die Lasten 15, 16 in Serie geschaltet werden. Im gesperrten Zustand trennt der erste Schalter 17 die Anordnungen aus den Verstärkerstufen 1, 2 und der ersten Last 15 einerseits und der dritten und vierten Verstärkerstufe 3, 4 und der zweiten Last 16 andererseits voneinander.

Ein erster Signaleingang 20, dem von einer externen, nicht dargestellten Signalquelle ein erstes zu verstärkendes Signal zuleitbar ist, ist unmittelbar mit dem Eingang 5 der ersten Verstärkerstufe 1 und über einen zweiten Schalter 18 mit dem Eingang 6 der zweiten Verstärkerstufe 2 verbunden. Entsprechend ist ein zweiter Signaleingang 21 für ein zweites zu verstärkendes Signal mit dem Eingang 7 der dritten Verstärkerstufe 3 unmittelbar und mit dem Eingang 8 der vierten Verstärkerstufe 4 über einen dritten Schalter 19 verbunden. Der zweite und der dritte Schalter 18 bzw. 19 sind als Umschalter ausgebildet, über die die Eingänge 6 bzw. 8 der zweiten bzw. vierten Verstärkerstufe 2 bzw. 4 wahlweise an einen gemeinsamen Ausgang 22 einer Bezugspotentialquelle 23 geschaltet werden können, die bevorzugt eine Spannung liefert, die dem halben Wert der Betriebsspannung entspricht.

Der erste, zweite und dritte Schalter 17, 18, 19 bilden gemeinsam eine Umschalteinrichtung zum Umschalten des Signalverstärkers nach Fig. 1 wahlweise in eine erste und eine zweite Schaltungskonfiguration. In der ersten Schaltungskonfiguration, die einem Aufbau aus zwei in Serie geschalteten Gegentaktverstärkern entspricht, ist der erste Schalter 17 leitend und befinden sich der zweite und dritte Schalter 18, 19 in den in Fig. 1 dargestellten Schalterstellungen, in denen die Eingänge 6 der zweiten Verstärkerstufe 2 und 8 der vierten Vertärkerstufe 4 gemeinsam mit dem Ausgang 22 der Bezugspotentialquelle 23 verbunden sind. Dem Eingang 6 der zweiten Verstärkerstufe 2, der als invertierender Eingang ausgebildet ist, und dem Eingang 8 der vierten Verstärkerstufe 4, der als nichtinvertierender Eingang ausgebildet ist, wird das Bezugspotential zugeführt, das auch an den Ausgangsanschlüssen 10 bzw. 12 der zweiten bzw. vierten Verstärkerstufe 2 bzw. 4 erscheint. Damit arbeitet die erste Verstärkerstufe 1 mit der ersten Last 15 unabhängig von der dritten Verstärkerstufe 3 mit der zweiten Last 16 auf dieses Bezugspotential. Die Lasten 15, 16 sind dabei in Serie geschaltet. Der Eingang 5 der ersten Verstärkerstufe 1 ist in Fig. 1 als nichtinvertierender Eingang, der Eingang 7 der dritten Verstärkerstufe 3 als invertierender Eingang ausgeführt. In einem Anwendungsbeispiel für den erfindungsgemäßen Signalverstärker, in dem dieser zwei Lautsprecher eines Stereokanals speist, die in einem Fahrzeug im vorderen bzw. im hinteren Bereich des Fahrgastraumes angeordnet sind, stimmen das erste und das zweite zu verstärkende Signal an den Signaleingängen 20, 21 überein. Die verstärkten Signale an den Ausgangsanschlüssen 9 bzw. 11 der ersten bzw. dritten Verstärkerstufe 1 bzw. 3 sind dann gegenphasig, so daß bei übereinstimmender Verstärkung und identischen Lasten (Lautsprechern) die zweite und die vierte Verstärkerstufe 2, 4 keinen Signalstrom führen. Damit ist die von der zweiten und der vierten Verstärkerstufe 2, 4 verursachte Verlustleistung sehr gering.

In der zweiten Schaltungskonfiguration wird der erste Schalter 17 gesperrt und werden der zweite und der dritte Schalter 18, 19 in ihre jeweils nicht dargestellte Schalterstellung umgeschaltet. Durch den zweiten Schalter 18 wird dann der Eingang 6 der zweiten Verstärkerstufe 2 mit dem ersten Signaleingang 20, durch den dritten Schalter 19 wird der Eingang 8 der vierten Verstärkerstufe 4 mit dem zweiten Signaleingang 21 verbunden. Die erste und die zweite Verstärkerstufe 1, 2 bilden nun einen Brückenverstärker und steuern mit den Signalen an ihren Ausgangsanschlüssen 9, 10 die erste Last 15 gegenphasig an. Entsprechend bilden die dritte und die vierte Verstärkerstufe 3, 4 einen zweiten Brückenverstärker für die zweite Last 16. Im vorstehend erläuterten Betriebsbeispiel werden dann die Lasten 15, 16 unabhängig voneinander, aber mit dem gleichen Signal phasenrichtig ausgesteuert, d.h. es kann während des Betriebes eine Umsteuerung zwischen den Schaltungskonfigurationen ohne Signalsprung oder sonstige Störung im Signal vorgenommen werden.

Zum Betätigen der Umschalteinrichtung 17, 18, 19 enthält der Signalverstärker nach Fig. 1 eine Steuerschaltung 24, die über eine erste Steuerleitung 25 mit dem ersten Schalter 17 und über eine zweite Steuerleitung 26 mit den Umschaltern 18, 19 verbunden ist. Die erste Verstärkerstufe 1 und die dritte Verstärkerstufe 3 enthalten je eine Detektionseinrichtung zum Detektieren des Klirrfaktors des Signals an ihrem jeweiligen Ausgangsanschluß 9 bzw. 11. Beispielsweise umfaßt diese Detektionseinrichtung eine Meßanordnung zum Messen des Augenblickswertes oder der Amplitude von Oberwellen des zu verstärkenden Signals bzw. des Signals am Ausgangsanschluß 9 bzw. 11. Wahlweise können auch nichtlineare Signalverzerrungen detektiert werden, oder der Übergang der ersten bzw. dritten Verstärkerstufe 1 bzw. 3 in einen Sättigungszustand wird detektiert Ein daraus gewonnenes Detektionssignal wird von der ersten bzw. dritten Verstärkerstufe 1 bzw. 3 an einem zugehörigen Detektionssignalausgang 27 bzw. 28 abgegeben und der Steuerschaltung 24, mit der die Detektionssignalausgänge 27, 28 verbunden sind, zugeleitet. Wird von der Steuerschaltung 24 in einer der Verstärkerstufen 1, 3 ein zu hoher Klirrfaktor oder ein Übergang in die Sättigung festgestellt, wird über die Steuerleitungen 25, 26 von der ersten Schaltungskonfiguration in die zweite Schaltungskonfiguration umgeschaltet.

Die erste und die dritte Verstärkerstufe 1, 3 sind ferner über eine dritte Steuerleitung 29 mit der Steuerschaltung 24 verbunden. Über diese dritte Steuerleitung 29 wird der ersten und der dritten Verstärkerstufe 1, 3 gemeinsam mit dem Betätigen der Umschalteinrichtung 17, 18, 19 ein Steuersignal zugeführt, durch welches in den Verstärkerstufen 1, 3 enthaltene Verstärkungs-Umsteuereinrichtungen betätigbar sind. Dadurch werden die Verstärkungsfaktoren der ersten und der dritten Verstärkerstufe 1, 3 von einem ersten Wert in der ersten Schaltungskonfiguration auf einen zweiten, niedrigeren Wert in der zweiten Schaltungskonfiguration umgesteuert. Beispielsweise wird der Verstärkungsfaktor jeder der Verstärkerstufen 1, 3 in der zweiten Schaltungskonfiguration um 6 dB gegenüber demjenigen in der ersten Schaltungskonfiguration verringert. Das Einsetzen der Wirkung der zweiten und der vierten Verstärkerstufe 2, 4 in der zweiten Schaltungskonfiguration erfolgt dann ohne Änderung der Steigung der Verstärkerkennlinie.

Die Detektionseinrichtung und die Steuerschaltung 24 können auch derart ausgebildet sein, daß sie aus einem Amplitudenverhältnis zwischen Grundschwingung und Oberwellen der Signale an den Ausgangsanschlüssen 9 bzw. 11, d.h. insbesondere zwischen Oberwellen, die im zu verstärkenden Signal an den Signaleingängen 20, 21 nicht enthalten sind, im zeitlichen Mittel den Klirrfaktor bestimmen. Diese Klirrfaktorbestimmung erfolgt in Abhängigkeit von der Signalamplitude bzw. der Amplitude der Grundschwingung. Aus demjenigen Wert der Signalamplitude, bei dem der Klirrfaktor einen vorgegebenen Grenzwert überschreitet, wird ein Umschaltpegel bestimmt. Der Augenblickswert des Signals am Signaleingang 20 bzw. 21 oder wahlweise am Ausgangsanschluß 9 bzw. 11 wird mit diesem Umschaltpegel verglichen. Überschreitet der Augenblickswert den Umschaltpegel, steuert die Steuerschaltung 24 von der ersten in die zweite Schaltungskonfiguration um. Dadurch, daß der Umschaltpegel stets dem Klirrfaktor nachgeführt wird, werden bei dieser Anordnung trotz der zeitlichen Mittelung auch Einflüsse beispielsweise einer schwankenden Betriebsspannung ausgeglichen.

In Fig. 1 sind weiterhin eine vierte und eine fünfte Steuerleitung 30 bzw. 31 dargestellt, die wahlweise vorhanden sein können. Über diese Steuerleitungen 30, 31 können entweder die zweite oder die vierte Verstärkerstufe 2 oder 4 in der ersten Schaltungskonfiguration in eine Betriebsart mit hochohmigem Ausgangsanschluß schaltbar sein. In einer praktischen Ausführungsform wird daher nur eine der beiden Steuerleitungen 30, 31 ausgeführt.

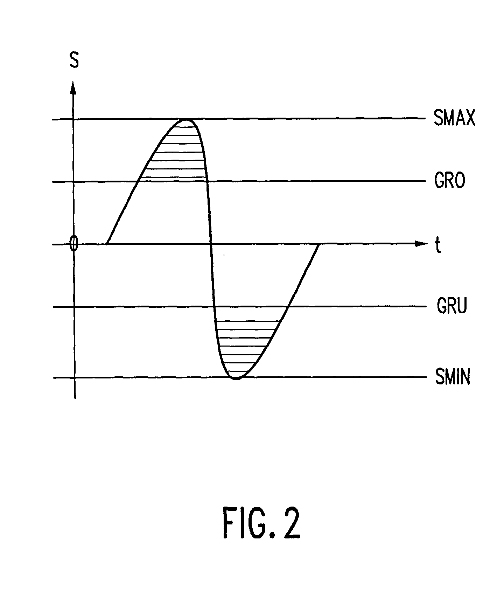

Fig. 2 zeigt schematisch den Einsatz der beiden Schaltungskonfigurationen in Abhängigkeit vom Augenblickswert des Signals an den Ausgangsanschlüssen 9 bzw. 11 der ersten bzw. dritten Verstärkerstufe 1 bzw. 3. Der Verlauf des Signals S über der Zeit t erstreckt sich um ein Bezugspotential 0 herum zwischen einem Minimalwert SMIN und einem Maximalwert SMAX. In einem Aussteuerungsbereich um das Bezugspotential 0 herum, welcher sich zwischen einem unteren Umschaltpegel GRU und einem oberen Umschaltpegel GRO erstreckt, befindet sich der Signalverstärker in der ersten Schaltungskonfiguration, außerhalb des durch die Umschaltpegel GRU und GRO festgelegten "Fensters" arbeitet der Signalverstärker in der zweiten Schaltungskonfiguration. Beim Durchlaufen einer Schwingungsperiode des Signals S wird im Beispiel nach Fig. 2 viermal ein Umschaltpegel über- bzw. unterschritten. Bei jedem Über- bzw. Unterschreiten wird die Schaltungskonfiguration umgeschaltet. Zur Verdeutlichung sind die Aussteuerungsbereiche, in denen die zweite Schaltungskonfiguration wirksam ist, mit einer waagerechten Schraffur unterlegt.

Ein vorteilhaftes Anwendungsgebiet des erfindungsgemäßen Signalverstärkers liegt im Bereich der Kraftfahrzeug-Audiotechnik und dort insbesondere bei den Lautsprecherverstärkern. Bei derartigen Geräten werden sehr geringe Verlustleistungen trotz hoher Signalleistungen an den Lautsprechern gefordert. Außerdem muß diese hohe Signalleistung sehr verzerrungsarm bereitgestellt werden. Der erfindungsgemäße Signalverstärker fußt dabei auf der Erkenntnis, daß ein durchschnittliches Audiosignal nur selten den Einsatz der zweiten Schaltungskonfiguration erfordert. Die Erfindung währleistet dabei einen verlust- und verzerrungsarmen Betrieb, wobei insbesondere eine Schaltungsanordnung ohne Auskoppelkondensatoren ermöglicht wird. Dadurch ist auch ein kostengünstiger und platzsparender Aufbau möglich; insbesondere kann der Signalverstärker in einem integrierten Bauteil zusammengefaßt sein. Die Detektion des Klirrfaktors erfolgt in vorteilhafter Weise entweder über die Bestimmung des Sättigungszustandes, vorzugsweise einer Sättigungsspannung der ausgangsseitigen Verstärkungselemente der Verstärkerstufen, oder durch einen Vergleich der Signalspannungen an den Signaleingängen mit einem entsprechenden Teil der Signale an den Ausgangsanschlüssen der Verstärkerstufen.

## Patentansprüche

1. Signalverstärker mit vier in zwei verschiedenen Schaltungskonfigurationen verbindbaren Verstärkerstufen (1, 2, 3, 4) wobei in der ersten Schaltungskonfiguration zwischen Ausgangsanschlüssen einer ersten (1) und einer dritten (3) der Verstärkerstufen eine Serienschaltung zweier Lasten (15, 16) angeordnet und einem Verbindungspunkt (10, 12) zwischen den Lasten ein Bezugspotential, einem Eingang (5) der ersten Verstärkerstufe (1) ein erstes zu verstärkendes Signal (20) und einem Eingang (7) der dritten Verstärkerstufe (3) ein zweites zu verstärkendes Signal (21) zuführbar ist, und wobei in der zweiten Schaltungskonfiguration zwischen dem Ausgangsanschluß (9) der ersten Verstärkerstufe (1) und einem Ausgangsanschluß (10) einer zweiten Verstärkerstufe (2) eine erste (15) der Lasten (15, 16) und zwischen dem Ausgangsanschluß (11) der dritten Verstärkerstufe (3) und einem Ausgangsanschluß (12) einer vierten Verstärkerstufe (4) eine zweite (16) der Lasten (15, 16) angeordnet und dem Eingang (5) der ersten Verstärkerstufe (1) sowie einem Eingang (6) der zweiten Verstärkerstufe (2) das erste zu verstärkende Signal (20) und dem Eingang (7) der dritten Verstärkerstufe (3) sowie einem Eingang (8) der vierten Verstärkerstufe (4) das zweite zu verstärkende Signal (21) zuführbar ist, und mit einer Umschalteinrichtung (17, 18, 19) zum Umschalten des Signalverstärkers wahlweise in eine der beiden Schaltungskonfigurationen, **gekennzeichnet durch**
eine Detektionseinrichtung (1, 3, 24) zum Detektieren des Klirrfaktors des Signals am Ausgangsanschluß (9, 11) der ersten (1) und/oder der dritten (3) Verstärkerstufe und zum Betätigen der Umschalteinrichtung (17, 18, 19) in Abhängigkeit vom detektierten Wert des Klirrfaktors.

2. Signalverstärker nach Anspruch 1, **dadurch gekennzeichnet,**
**daß** durch die Umschalteinrichtung in die erste Schaltungskonfiguration umgeschaltet werden kann, wenn der detektierte Wert des Klirrfaktors einen vorgebbaren Grenz wert unterschreitet, und daß anderenfalls in die zweite Schaltungskonfiguration umgeschaltet werden kann.

3. Signalverstärker nach Anspruch 1 oder 2, **dadurch gekennzeichnet,**
**daß** die Detektionseinrichtung einen Augenblickswert des Klirrfaktors bestimmt.

4. Signalverstärker nach Anspruch 1, 2 oder 3, **dadurch gekennzeichnet,**
**daß** die Detektionseinrichtung einen Übergang der ersten und/oder der dritten Verstärkerstufe in einen Sättigungszustand detektiert und daß vor Erreichen des Sättigungszustandes in die erste und im Sättigungszustand in die zweite Schaltungskonfiguration umgeschaltet wird.

5. Signalverstärker nach Anspruch 1 oder 2, **dadurch gekennzeichnet,**
**daß** die Detektionseinrichtung den Klirrfaktor in Abhängigkeit von der Signalamplitude bestimmt und bei Überschreiten eines Grenzwertes aus der Signalamplitude einen Umschaltpegel festlegt, bei dessen Überschreiten durch den Augenblickswert des Signals von der ersten in die zweite Schaltungskonfiguration umgeschaltet wird.

6. Signalverstärker nach einem der vorhergehenden Ansprüche, **gekennzeichnet durch**
je eine gemeinsam mit der Umschalteinrichtung betätigbare Verstärkungs-Umsteuereinrichtung in der ersten und der dritten Verstärkerstufe zum Umsteuern der Verstärkungsfaktoren dieser Verstärkerstufen auf einen ersten Wert in der ersten Schaltungskonfiguration und einen zweiten, niedrigeren Wert in der zweiten Schaltungskonfiguration.

7. Signalverstärker nach einem der vorhergehenden Ansprüche, **dadurch gekennzeichnet,**
**daß** das Bezugspotential dem Verbindungspunkt der Lasten in der ersten Schaltungskonfiguration über die zweite und/oder die vierte Verstärkerstufe zuleitbar ist.

8. Signalverstärker nach Anspruch 7, **dadurch gekennzeichnet,**
**daß** entweder die zweite oder die vierte Verstärkerstufe in der ersten Schaltungskonfiguration in eine Betriebsart mit hochohmigem Ausgangsanschluß schaltbar ist.

## Claims

1. A signal amplifier having four amplifier stages (1, 2, 3, 4) which can be arranged in two different configuration modes, in the first configuration mode of which a series arrangement of two loads (15, 16) is arranged between output terminals of a first (1) and a third (3) one of the amplifier stages, a reference potential can be applied to a node (10, 12) between the loads, a first signal (20) to be amplified can be applied to an input (5) of the first amplifier stage (1) and a second signal (21) to be amplified can be applied to an input (7) of the third amplifier stage (3), and in the second configuration mode a first one (15) of the loads is arranged between the output terminal (9) of the first amplifier stage (1) and an output terminal (10) of a second amplifier stage (2) and a second one (16) of the loads is arranged between the output terminal (11) of the third amplifier stage (3) and an output terminal (12) of a fourth amplifier stage (4), and the first signal (30) to be amplified can be applied to the input (5) of the first amplifier stage (1) and an input (6) of the second amplifier stage (2) and the second signal (21) to be amplified can be applied to the input (7) of the third amplifier stage (3) and an input (8) of the fourth amplifier stage (4), and having a switching device (17, 18, 19) for switching the signal amplifier selectively to one of the two configuration modes, **characterized by**
a detection device (1, 3, 24) for detecting the distortion factor of the signal at the output terminal (9, 11) of the first (1) and/or the third (3) amplifier stage and for actuating the switching device (17, 18, 19) in dependence on the detected value of the distortion factor.

2. A signal amplifier as claimed in Claim 1, **characterized in that**
switching to the first configuration mode by the switching device is possible if the detected value of the distortion factor becomes smaller than a given limit value and, in the other case, switching to the second configuration mode is possible.

3. A signal amplifier as claimed in Claim 1 or 2, **characterized in that**
the detection device determines an instantaneous value of the distortion factor.

4. A signal amplifier as claimed in Claim 1, 2 or 3, **characterized in that**
the detection device detects a transition to a saturation state of the first and/or the third amplifier stage, and switching to the first configuration mode is effected before the saturation state is reached and switching to the second configuration mode is effected in the saturation state.

5. A signal amplifier as claimed in Claim 1 or 2, **characterized in that**
the detection device determines the distortion factor in dependence on the signal amplitude and derives a switching level from the signal amplitude when a limit value is exceeded, switching from the first to the second configuration mode being effected when the instantaneous value of the signal exceeds said switching level.

6. A signal amplifier as claimed in any one of the preceding Claims, **characterized by**
a gain control device in each one of the first and second amplifier stages, which gain control device can be actuated concurrently with the switching device to set the gain factors of these amplifier stages to a first value in the first configuration mode and to a smaller second value in the second configuration mode.

7. A signal amplifier as claimed in any one of the preceding Claims, **characterized in that**
in the first configuration mode the reference potential can be applied to the node between the loads via the second and/or the fourth amplifier stage.

8. A signal amplifier as claimed in Claim 7, **characterized in that**
in the first configuration mode either the second or the fourth amplifier stage can be switched to operation with a high-impedance output terminal.

## Revendications

1. Amplificateur de signaux avec quatre étage d'amplification (1,2,3,4) à relier dans deux configurations de circuit différentes, dans lequel un montage en série de deux charges (15,16) est disposé dans la première configuration de circuit entre les bornes de sortie d'un premier (1) et d'un troisième (3) des étage d'amplification et un potentiel de référence peut être amené à un point de liaison (10,12) entre les charges, un premier signal (20) à amplifier à une entrée (5) du premier étage d'amplification (1) et un deuxième signal (21) à amplifier à une entrée (7) du troisième étage d'amplification (3), une première (15) des charges (15,16) est disposée dans la deuxième configuration de circuit entre la borne de sortie (5) du premier étage d'amplification (1) et une borne de sortie (10) d'un deuxième étage d'amplification (2) et une deuxième (16) des charges (15,16) entre la borne de sortie (11) du troisième étage d'amplification (3) et une borne de sortie (12) d'un quatrième étage d'amplification (4) et le premier signal à amplifier (20) peut être amené à l'entrée (5) du premier étage d'amplification (1) et à une entrée (6) du deuxième étage d'amplification (2) et le deuxième signal (21) à amplifier à l'entrée (7) du troisième étage d'amplification (3) ainsi qu'à une entrée (8) du quatrième étage d'amplification (4) et avec un dispositif de commutation (17,18,19) pour la commutation de l'amplificateur de signaux au choix dans l'une des deux configurations du circuit,
**caractérisé par**
un dispositif de détection (1,3,24) pour détecter le facteur de distorsion harmonique du signal à la borne de sortie (9,11) des premier (1) et/ou troisième (3) étages d'amplification et pour actionner le dispositif de commutation (17,18,19) en fonction de la valeur détectée du facteur de distorsion harmonique.

2. Amplificateur de signaux selon la revendication 1, **caractérisé en ce**
**que** le dispositif de commutation permet de commuter dans la première configuration de circuit lorsque la valeur détectée du facteur de distorsion harmonique passe sous une valeur limite à déterminer préalablement et, dans le cas contraire, de commuter dans la deuxième configuration de circuit.

3. Amplificateur de signaux selon l'une des revendications 1 ou 2, **caractérisé en ce que** le dispositif de détection détermine une valeur instantanée du facteur de distorsion harmonique.

4. Amplificateur de signaux selon l'une des revendications 1, 2 ou 3, **caractérisé en ce**
**que** le dispositif de détection détecte un passage du premier et/ou du troisième étage d'amplification dans un état de saturation et qu'avant d'atteindre l'état de saturation, il est commuté dans la première configuration de circuit et, dans l'état de saturation, dans la deuxième configuration de circuit.

5. Amplificateur de signaux selon l'une des revendications 1 ou 2, **caractérisé en ce**
**que** le dispositif de détection détermine le facteur de distorsion harmonique en fonction de l'amplitude du signal et, en cas de dépassement d'une valeur limite, fixe à partir de l'amplitude du signal un niveau de commutation dont le dépassement par la valeur instantanée du signal provoque une commutation de la première configuration de circuit dans la deuxième.

6. Amplificateur de signaux selon l'une des revendications précédentes, **caractérisé par**
un dispositif de commutation de l'amplification actionnable en même temps que le dispositif de commutation dans les premier et troisième étages d'amplification en vue de la commutation des facteurs d'amplification de ces étages d'amplification à une première valeur dans la première configuration de circuit et une deuxième valeur inférieure dans la deuxième configuration de circuit.

7. Amplificateur de signaux selon l'une des revendications précédentes, **caractérisé en ce**
**que** le potentiel de référence peut être amené au point de jonction des charges dans la première configuration de circuit par l'intermédiaire des deuxième et/ou quatrième étages d'amplification.

8. Amplificateur de signaux selon la revendication 7, **caractérisé en ce**
**que** soit le deuxième, soit le quatrième étage d'amplification peut être commuté dans la première configuration de circuit dans un mode de fonctionnement avec une borne de sortie à haute impédance.
